# DEMANDE DE BREVET EUROPEEN

(11) **EP 2 521 161 A1**
(43) Date de publication de la demande: **07.11.2012**
(21) Numéro de dépôt: 12166890.9
(22) Date de dépôt: 04.05.2012
(51) Int. Cl.: H01L 21/02, H01L 29/06, H01L 29/76, H01L 21/334, B82Y 40/00, B82Y 10/00

(54) **Procede de realisation de nanocristaux de semi-conducteur**

(30) Priorité: 06.05.2011 FR 1153927
(71) Demandeur: Commissariat à l'Énergie Atomique et aux Énergies Alternatives, 75015 Paris (FR); Centre National de la Recherche Scientifique, 75016 Paris (FR)
(72) Inventeur: Borowik, Lukasz, 38360 Sassenage (FR); Barbe, Jean-Charles, 38160 Izeron (FR); Bussmann, Ezra, Caballo, NM 87931 (US); Cheynis, Fabien, 13010 Marseille (FR); Leroy, Frédéric, 13013 Marseille (FR); Mariolle, Denis, 38100 Grenoble (FR); Müller, Pierre, 13008 Marseille (FR)
(74) Mandataire: Ilgart, Jean-Christophe

(57) **Abrégé**

Procédé de réalisation de nanocristaux de semi-conducteur (108), comportant au moins les étapes de :
- formation d'espèces chimiques carbonées solides sur une couche mince de semi-conducteur disposée sur au moins une couche diélectrique (104), les dimensions et la densité des espèces chimiques carbonées formées sur la couche mince de semi-conducteur étant fonction des dimensions et de la densité souhaitées des nanocristaux de semi-conducteur,
- recuit de la couche mince de semi-conducteur, réalisant un démouillage du semi-conducteur et formant, sur la couche diélectrique, les nanocristaux de semi-conducteur.

## Description

### DOMAINE TECHNIQUE

L'invention concerne un procédé de réalisation de nanocristaux de semi-conducteur obtenus par démouillage d'une couche mince de semi-conducteur disposée sur une couche diélectrique, et pouvant être utilisés pour la réalisation de dispositifs microélectroniques et/ou nanoélectroniques, par exemple des dispositifs mémoire ou des dispositifs émissifs lumineux de type LED.

L'invention concerne également un procédé de réalisation d'une couche diélectrique poreuse faisant appel à des nanocristaux de semi-conducteur.

L'invention concerne également un procédé de réalisation de nanocristaux de semi-conducteur positionnés avec précision dans l'épaisseur d'un empilement de couches comprenant au moins un matériau diélectrique.

### ÉTAT DE LA TECHNIQUE ANTÉRIEURE

Pour réaliser des nanocristaux de semi-conducteur, c'est-à-dire des agrégats de semi-conducteur dont les dimensions peuvent être comprises entre environ quelques nanomètres et quelques centaines de nanomètres, il est connu de réaliser un démouillage d'une couche mince de silicium disposée sur une couche de SiO₂. En effet, lorsque la couche mince de silicium, formant par exemple la couche active, ou couche supérieure, d'un substrat SOI (silicium sur isolant), est soumise à un recuit à haute température, par exemple comprise entre environ 650°C et 1250°C, le silicium de cette couche mince se rétracte progressivement sur lui-même en formant des nanocristaux, ou agrégats, de silicium.

Le document EP 1 619 277 A2 décrit qu'il est possible de localiser précisément les zones où l'on souhaite qu'une partie de la couche de semi-conducteur forme des nanocristaux par démouillage, en réalisant notamment un dopage et une insolation par faisceau d'électrons de ces zones, préalablement à un recuit à haute température sous atmosphère hydrogénée.

Le document « Agglomeration process in thin-silicon-, strained silicon-, and silicon germanium-on-insulator substrates » de G. Capellini et al., Journal of applied physics, vol. 105, 2009, décrit que le démouillage peut être influencé selon que l'on utilise une couche de semi-conducteur contrainte ou non. Plus la contrainte bi-axiale à laquelle est soumis le semi-conducteur est importante et/ou plus la couche de semi-conducteur est mince, plus la taille des nanocristaux de semi-conducteur sera réduite et plus la densité des nanocristaux sera importante. En augmentant la valeur de la contrainte bi-axiale, il est possible de réduire les dimensions des nanocristaux, dans le plan de la couche de semi-conducteur, jusqu'à environ 145 nm.

Les dimensions de ces nanocristaux sont toutefois trop importantes pour qu'ils puissent être utilisés dans certains dispositifs électroniques de dimensions nanométriques, tels que les dispositifs mémoires dans lesquels les dimensions des zones actives électriques doivent parfois être inférieures à 145 nm.

### EXPOSÉ DE L'INVENTION

Un but de la présente invention est de proposer un procédé de réalisation de nanocristaux de semi-conducteur permettant de contrôler la densité et les dimensions des nanocristaux de semi-conducteur, et permettant de réaliser des nanocristaux de faibles dimensions, par exemple inférieures à environ 50 nm.

Pour cela, la présente invention propose un procédé de réalisation de nanocristaux de semi-conducteur, comportant au moins les étapes de :
- formation d'espèces chimiques carbonées sur une couche mince de semi-conducteur disposée sur au moins une couche diélectrique, la densité des espèces chimiques carbonées formées sur la couche mince de semi-conducteur étant fonction des dimensions et de la densité souhaitées des nanocristaux de semi-conducteur ;
- recuit de la couche mince de semi-conducteur, réalisant un démouillage du semi-conducteur et formant, sur la couche diélectrique, les nanocristaux de semi-conducteur.

Les espèces chimiques carbonées formées sur la couche mince de semi-conducteur sont solides, correspondant par exemple à des particules solides.

Le procédé de la présente invention se base sur le phénomène physique de démouillage se produisant lorsqu'une couche mince de semi-conducteur, par exemple du silicium, est soumise à un traitement thermique à haute température.

Le terme « espèce chimique carbonée » désigne ici du carbone sous forme atomique et/ou au moins un composé organique, c'est-à-dire un composé comprenant au moins un atome de carbone lié à au moins un atome d'hydrogène, tel que par exemple l'un des composés organiques de la liste suivante donnée de façon indicative et non exclusive : Styrène ; pyrrolidine ; 1-(1-propenyl) ; benzaldéhyde ; Phénol ; cyclopropane, octyl ; 1-hexanol, 2-ethyl- ; 2,2,6,6-tetramethyl-4-piperidone ; acide benzoïque ; N-(1-cyano-1-methylethyl) isobutyramide ; caprolactame ; anhydride phtalique ; tétradécène ; N(2)-isobutyryl-2-methylalaninamide ; di-epi-alpha-cédrène ; pentadécène ; hexadécène ; TXIB ; Diethyl phtalate ; Heptadécène ; acide benzoïque, ethylhexylester ; Diisobutyl phtalate ; 7,9-di-tert-butyl-oxaspiro(4,5)deca-6,9-diene-2,8-dione ; Dibutyl phtalate ; 2,6-Ditert-butyl-4-methylphenylmethylcarbamate.

Le procédé selon l'invention permet de contrôler la taille et la densité des nanocristaux de semi-conducteur obtenus par démouillage. Pour cela, l'invention propose de contrôler le démouillage grâce au contrôle préalable de la densité et des dimensions des espèces chimiques carbonées présentes, déposées ou formées, sur la couche mince de semi-conducteur, ce qui permet notamment, par rapport aux procédés de démouillage de l'art antérieur, et pour une couche mince de semi-conducteur de même épaisseur, d'obtenir des nanocristaux de dimensions réduites, notamment inférieures à environ 50 nm.

La formation d'espèces chimiques carbonées sur la couche mince de semi-conducteur peut comporter au moins un recuit de la couche mince de semi-conducteur formant des agrégats d'impuretés et/ou des agrégats de carbone, par exemple composés de carbure de semi-conducteur, correspondant aux espèces chimiques carbonées.

La formation d'espèces chimiques carbonées sur la couche mince de semi-conducteur peut comporter une étape de traitement chimique de la couche mince de semi-conducteur apte à réduire une quantité d'impuretés se trouvant sur la couche mince de semi-conducteur, et un recuit de la couche mince de semi-conducteur décomposant les impuretés et formant des agrégats d'impuretés correspondant aux espèces chimiques carbonées. Un tel recuit peut être réalisé à une température comprise entre environ 600°C et 800°C.

L'étape de traitement chimique peut comporter l'application d'une solution composée de H₂O₂ et de H₂SO₄ contre la couche mince de semi-conducteur.

La formation d'espèces chimiques carbonées sur la couche mince de semi-conducteur peut comporter une étape de dépôt de carbone sur la couche mince de semi-conducteur, et un recuit de la couche mince de semi-conducteur décomposant le carbone déposé et formant des agrégats de carbone, ou nanocristaux carbonés, correspondant auxdites espèces chimiques carbonées. Un tel recuit peut être réalisé à une température comprise entre environ 600°C et 800°C, ou à une température supérieure à 800°C. Lorsque la température est supérieure à 800°C, des agrégats carbonés se forment mais la formation d'agrégats est alors couplée au démouillage.

Le dépôt de carbone sur la couche mince de semi-conducteur peut être réalisé dans un environnement dont la pollution environnementale peut être composée d'espèces carbonées et peut comporter une insolation de la couche mince de semi-conducteur par un faisceau d'électrons. Une telle insolation réalise un craquage desdites espèces carbonées et dépose le carbone sous forme atomique en surface de la couche mince de semi-conducteur.

Le semi-conducteur de la couche mince peut être contraint, par exemple de manière uni-axiale, la valeur de cette contrainte étant choisie en fonction des dimensions et de la densité souhaitées des nanocristaux de semi-conducteur.

Le recuit de la couche mince de semi-conducteur peut être réalisé à une température comprise entre environ 600°C et 1250°C et dans un environnement sous ultravide, c'est-à-dire à une pression comprise entre environ 10⁻⁷ mbar et 10⁻¹² mbar.

Les étapes de formation des espèces chimiques carbonées et de recuit de la couche mince de semi-conducteur peuvent être mises en oeuvre dans un microscope électronique à balayage.

Le recuit de la couche mince de semi-conducteur peut être prolongé jusqu'à ce que les nanocristaux de semi-conducteur réagissent chimiquement avec la couche diélectrique en formant une pluralité de trous traversant partiellement ou totalement la couche diélectrique.

Le procédé peut comporter en outre, après l'étape de recuit de la couche mince de semi-conducteur, une étape de bouchage des trous par un dépôt d'au moins un matériau dans les trous.

L'invention concerne également un procédé de réalisation d'une couche diélectrique poreuse, comportant au moins la mise en oeuvre d'un procédé de réalisation de nanocristaux de semi-conducteur tel que décrit ci-dessus, dans lequel le recuit de la couche mince de semi-conducteur peut être prolongé jusqu'à ce que les nanocristaux de semi-conducteur réagissent chimiquement avec la couche diélectrique en formant une pluralité de pores traversant totalement ou partiellement la couche diélectrique.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 et 2 représentent les étapes d'un procédé de réalisation de nanocristaux de semi-conducteur, objet de la présente invention ;
- les figures 3A et 3B représentent les nanocristaux obtenus par la mise en oeuvre d'un procédé de réalisation de nanocristaux de semi-conducteur, objet de la présente invention ;
- la figure 4 représente une couche diélectrique poreuse obtenue en poursuivant le recuit réalisé lors d'un procédé de réalisation de nanocristaux de semi-conducteur, objet de la présente invention ;
- les figures 5 à 9 représentent plusieurs structures obtenues grâce au procédé de réalisation de nanocristaux de semi-conducteur, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

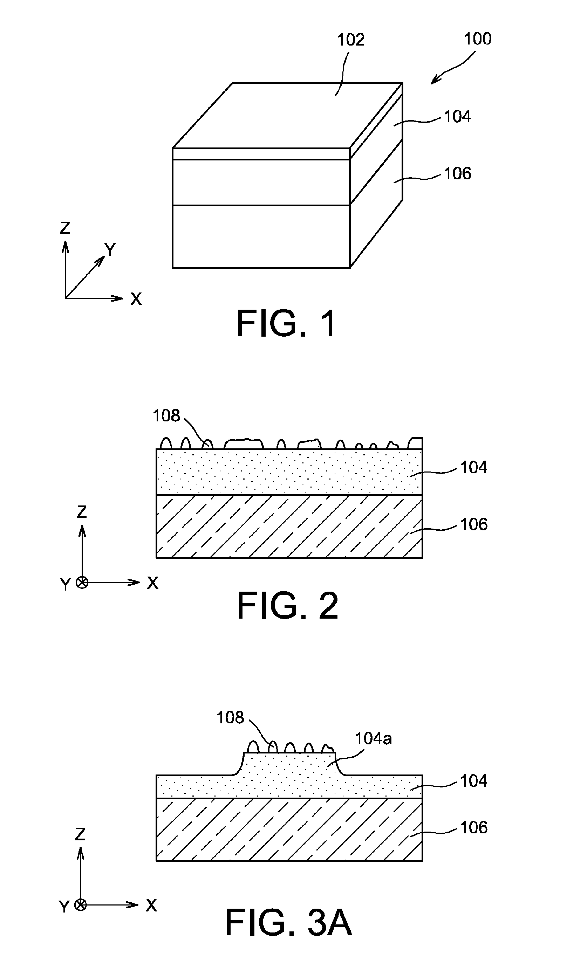

On décrit, en liaison avec les figures 1 et 2, les étapes d'un procédé de réalisation de nanocristaux de semi-conducteur selon un premier mode de réalisation.

Le procédé de réalisation de nanocristaux de semi-conducteur est mis en oeuvre à partir d'un premier substrat SOI 100 (représenté sur la figure 1) comprenant une couche mince (d'épaisseur inférieure ou égale à environ 1 µm, et de préférence comprise entre environ 1 nm et 100 nm) de silicium monocristallin 102, d'orientation cristalline (001), recouvrant une couche diélectrique 104 enterrée composée de SiO₂ qui repose sur une couche épaisse de silicium monocristallin 106 formant la couche support du substrat SOI.

Le procédé est également mis en oeuvre pour un deuxième, un troisième et un quatrième substrat SOI, de structures similaires à celle du premier substrat SOI 100, mais dans lesquels la couche mince de silicium 102 est composée de silicium dit contraint de manière bi-axiale dans le plan de la couche 102, c'est-à-dire dans les deux directions X et Y représentées sur la figure 1. Cet état de contrainte bi-axiale est équivalent à une déformation bi-axiale subie par le silicium de la couche mince 102 dans les deux directions X et Y, le passage de l'état de contrainte à l'état de déformation se faisant de façon bijective par la loi linéaire dite « loi de Young ». Les déformations bi-axiales subies par le silicium des couches minces des deuxième, troisième et quatrième substrats sont respectivement égales à 0,76 %, 1,15 % et 1,56 %, le deuxième substrat correspondant donc à un substrat sSOI 0,76 %, le troisième substrat correspondant à un substrat sSOI 1,15 %, et le quatrième substrat correspondant à un substrat sSOI 1,56 %.

Les couches minces de silicium de ces quatre substrats ont subies une étape d'amincissement (obtenue par oxydation à haute température suivie d'une gravure à l'acide fluorhydrique), la couche mince 102 de silicium du premier substrat SOI ayant une épaisseur égale à environ 7 nm, celle du deuxième substrat sSOI 0,76 % ayant une épaisseur égale à environ 7,5 nm, celle du troisième substrat sSOI 1,15 % ayant une épaisseur égale à environ 8,6 nm, et celle du quatrième substrat sSOI 1,56 % ayant une épaisseur égale à environ 8,2 nm.

De manière générale, la couche diélectrique 104 sur laquelle est disposée la couche mince de semi-conducteur 102 peut correspondre à une couche ou à un empilement de plusieurs couches composées de SiO₂ et/ou de Si₃N₄ et/ou de SiₓN_{y} (nitrure de silicium non stoechiométrique) et/ou de SiₓO_{y}N_{z} et/ou de tout autre matériau diélectrique. De plus, la ou au moins l'une de ces couches diélectriques peut être intrinsèquement contrainte, ou pré-contrainte, afin que la couche mince de semi-conducteur 102 devienne également contrainte une fois la gravure d'un motif réalisée dans la couche 102 et dans tout ou partie de l'épaisseur de la couche pré-contrainte intégrée dans l'empilement 104. De plus, le semi-conducteur de la couche mince 102 peut être un autre semi-conducteur que du silicium, par exemple du germanium ou un alliage de silicium et de germanium, ou encore un matériau III-V, par exemple du GaN et/ou de l'AsGa et/ou de l'AlGaN et/ou de l'InGaN. Si la couche mince 102 n'est pas gravée, et si le semi-conducteur de la couche mince 102 est de même nature que celui de la couche support 106 qui assure la rigidité de l' empilement formé par les couches 102, 104 et 106, le semi-conducteur de la couche mince 102 sera contraint de façon marginale. Si le semi-conducteur de la couche mince 102 n'est pas de même nature que celui de la couche support 106, le semi-conducteur de la couche mince 102 sera dans un état de contrainte bi-axiale lié à un écart de coefficient de dilatation thermique Δα et un écart de température ΔT entre la température de formation de la couche mince 102 et la température de recuit conduisant au démouillage de la couche mince 102. La couche mince 102 est alors dans un état de déformation bi-axiale Δα×ΔT équivalent à l'état de contrainte bi-axiale précédemment mentionné.

La couche support 106 peut être formée d'une seule couche ou d'un empilement de plusieurs matériaux comprenant par exemple du silicium dopé, du germanium et/ou un alliage de type Si₁₋ₓGeₓ, où x représente la concentration en germanium de l'alliage tel que 0 ≤ x ≤ 1. Cet empilement de matériaux différents peut être défini sur une partie seulement de la couche support 106, par exemple en réalisant une implantation de dopants à travers un masque réalisant un dopage local d'au moins l'un des matériaux semi-conducteur de la couche support 106.

A partir des quatre substrats précédemment décrits, on réalise des échantillons de largeur égale à environ 5 mm et de longueur égale à environ 10 mm (dimensions dans le plan (X,Y) représenté sur la figure 1). Du fait que ces dimensions soient bien supérieures à l'épaisseur totale de chaque substrat qui correspond à l'épaisseur des échantillons, ces dimensions sont donc sans influence sur le processus de démouillage de la couche mince de semi-conducteur qui sera réalisé par la suite. Les réalisations illustrées ici sont donc représentatives de ce qui se passe à l'échelle d'un wafer dont le diamètre est grand devant l'épaisseur de l'empilement 102/104/106.

On réalise tout d'abord un traitement de la couche mince de semi-conducteur 102 afin de former, en surface de cette couche mince de semi-conducteur, des espèces chimiques carbonées.

Dans un premier mode de réalisation, on réalise tout d'abord un traitement chimique de la surface supérieure de la couche mince de silicium 102.

En effet, des impuretés, comprenant des espèces chimiques carbonées, se trouvent naturellement en surface de la couche mince de silicium 102. Ces impuretés proviennent de la pollution environnementale dans laquelle se trouve le substrat, par exemple la pollution que l'on trouve naturellement dans un microscope électronique à balayage.

On réalise donc un traitement chimique de la surface de la couche mince de semi-conducteur 102 permettant de contrôler, et notamment réduire, la quantité d'impuretés présentes en surface de la couche mince 102. Ce traitement chimique peut être réalisé en utilisant une solution de type piranha (mélange à concentration variable d'acide sulfurique (H₂SO₄) et de peroxyde d'hydrogène (H₂O₂)), appliquée à une température par exemple égale à environ 140°C pendant une durée égale à environ 20 mn, et un oxyde gravant tamponné (BOE) appliqué pendant environ 20 secondes afin de supprimer d'éventuelles portions d'oxyde de semi-conducteur présentes sur la couche mince de silicium 102.

En faisant subir ensuite aux substrats un recuit à une température comprise par exemple entre environ 600°C et 800°C, ces impuretés se décomposent et forment des agrégats d'impuretés dont la densité, en surface de la couche mince 102, peut être comprise entre environ 0,1 et 1000 agrégats/µm². Dans l'exemple décrit ici, c'est-à-dire dans les conditions d'application de la solution chimique décrites précédemment suivi d'un recuit à une température comprise entre environ 600°C et 800°C (par exemple égale à environ 800°C), les agrégats d'impuretés sont formés sur la couche mince 102 avec une densité égale à environ 500 agrégats/µm². Ces agrégats sont principalement constitués de carbure de semi-conducteur, ici du carbure de silicium (SiC) du fait que la couche 102 est composée de silicium, et peuvent contenir des produits de décomposition des impuretés initiales (hydrogène, azote, etc.), et ont une hauteur (dimension selon l'axe Z) par exemple comprise entre environ 1 et 4 nm.

Après avoir formé les espèces chimiques carbonées sur la couche mince de semi-conducteur 102, on réalise un recuit à haute température (par exemple égale à environ 800°C, mais pouvant être comprise entre environ 600°C et 1250°C) entrainant le démouillage du semi-conducteur de la couche mince, et formant des nanocristaux de silicium 108 sur la couche diélectrique 104. La température de nucléation des agrégats de SiC peut être inférieure à la température à partir de laquelle commence le démouillage du semi-conducteur. Ce recuit haute température peut être réalisé à une température différente de celle du recuit précédemment mis en oeuvre et formant les agrégats d'impuretés. Toutefois, ces deux recuits peuvent être réalisés de manière continue à une même température, par exemple égale à environ 800°C, ou plus généralement comprise entre environ 600°C et 800°C.

Pour le premier substrat SOI 100, le démouillage du silicium de la couche mince 102 forme des nanocristaux de silicium 108 dont la hauteur moyenne est égale à environ 47 nm et dont la surface (dans le plan(X,Y), mesurée à une distance d'environ 20 nm de la couche diélectrique 104) est en moyenne égale à environ 15600 nm². A titre de comparaison, lorsque l'on réalise un recuit similaire du premier substrat SOI 100 entrainant le démouillage du silicium de la couche mince 102, mais sans avoir au préalable réalisé le traitement chimique permettant de réduire la quantité d'espèces chimiques carbonées sur la couche mince 102, la hauteur moyenne des nanocristaux de silicium est égale à environ 68 nm et leur surface moyenne est égale à environ 26000 nm². Pour le deuxième substrat sSOI 0,76 %, la hauteur moyenne des nanocristaux de silicium 108 est égale à environ 41 nm et la surface moyenne est égale à environ 17000 nm² (A titre de comparaison, sans le traitement chimique réduisant la quantité d'espèces chimiques carbonées en surface de la couche mince de semi-conducteur 102, la hauteur moyenne des nanocristaux est égale à environ 71 nm et leur surface moyenne est égale à environ 36500 nm²). Pour le quatrième substrat sSOI 1,56 %, la hauteur moyenne des nanocristaux de silicium 108 est égale à environ 40 nm et la surface moyenne est égale à environ 12000 nm² (A titre de comparaison, sans le traitement chimique réduisant la quantité d'espèces chimiques carbonées en surface de la couche mince de semi-conducteur 102, la hauteur moyenne des nanocristaux est égale à environ 51 nm et la surface moyenne est égale à environ 22000 nm²).

Ainsi, plus la densité d'agrégats, ou nanocristaux, carbonés formés sur la couche mince de semi-conducteur 102 sera importante, plus les dimensions des nanocristaux de semi-conducteur obtenus par démouillage seront faibles.

Les résultats ci-dessus montrent également que plus la contrainte subie par le semi-conducteur est importante, plus les dimensions des nanocristaux de semi-conducteur sont réduites.

En l'absence ou en présence de faibles quantités d'espèces chimiques carbonées, c'est-à-dire conduisant à une densité d'agrégats, ou nanocristaux, carbonés inférieure ou égale à la densité de nanocristaux de semi-conducteur obtenus après démouillage, par exemple en minimisant la pollution carbonée environnementale en optimisant (c'est-à-dire en réduisant) la durée d'exposition du substrat à une pollution environnementale entre l'étape d'amincissement et le recuit sous ultravide, on obtient, pour une couche mince de silicium 102 d'épaisseur comprise entre environ 7 nm et 9 nm, des nanocristaux de silicium de dimensions et de densités suivante :
- pour le premier substrat SOI, la densité des nanocristaux de silicium est égale à environ 2,6 nanocristaux/µm² la hauteur moyenne de ces nanocristaux étant égale à environ 100 nm et leur surface moyenne, mesurée à environ 20 nm de l'interface entre les couches 102 et 104, étant égale à environ 39200 nm² ;
- pour le deuxième substrat sSOI 0,76%, la densité des nanocristaux de silicium est égale à environ 5,6 nanocristaux/µm², la hauteur moyenne de ces nanocristaux étant égale à environ 75 nm et leur surface moyenne, mesurée à environ 20 nm de l'interface entre les couches 102 et 104, étant égale à environ 28100 nm² ;
- pour le troisième substrat sSOI 1,15%, la densité de nanocristaux de silicium obtenue est égale à environ 10,1 nanocristaux/µm², la hauteur moyenne de ces nanocristaux étant égale à environ 60 nm et leur surface moyenne, mesurée à environ 20 nm de l'interface entre les couches 102 et 104, étant égale à environ 18500 nm² ;
- pour le quatrième substrat sSOI 1,56%, la densité de nanocristaux de silicium obtenue est égale à environ 17,2 nanocristaux/µm², la hauteur moyenne de ces nanocristaux étant égale à environ 45 nm et leur surface moyenne, mesurée à environ 20 nm de l'interface entre les couches 102 et 104, étant égale à environ 13500 nm².

La déformation subie par le semi-conducteur contraint peut atteindre environ 1,56% pour une épaisseur de couche de l'ordre de 10 nm ou moins. Cette déformation peut être plus importante mais dans ce cas, la couche est réalisée avec une épaisseur plus faible afin que celle-ci ne soit pas supérieure à une épaisseur critique au-delà de laquelle la couche relaxe plastiquement par émission de dislocations.

Le recuit haute température, entrainant le démouillage du semi-conducteur, est mis en oeuvre dans un environnement sous vide UHV (« Ultra High Vacuum »), c'est-à-dire sous ultravide, par exemple à une pression égale à environ 10⁻⁹ mbar. Ce recuit est par exemple mis en oeuvre dans un microscope électronique à balayage (MEB) ou un microscope à force atomique (AFM), tel qu'un microscope du type Veeco Dimension 3100. Le recuit est par exemple réalisé à une température comprise entre environ 700°C et 1000°C, et par exemple à une température égale à environ 800°C +/- 10°C, pendant une durée comprise entre quelques minutes et quelques dizaines de minutes (par exemple 10 minutes).

Du fait que la cinétique du démouillage soit commandée par diffusion de surface, plus la température du recuit sera élevée, plus la durée du recuit permettant de réaliser le démouillage du semi-conducteur de la couche mince 102 sera courte.

Dans un second mode de réalisation, l'étape de traitement chimique de la couche mince de silicium 102 peut être remplacée par un dépôt d'espèces chimiques carbonées, formant sur au moins une partie de la couche mince 102 une couche de carbone dont l'épaisseur sera choisie en fonction de la densité souhaitée de nanocristaux de silicium, ainsi que des dimensions souhaitées de ces nanocristaux de silicium.

La couche de carbone est formée en insolant, ou en irradiant, la couche mince de silicium 102 par un faisceau d'électrons pendant une durée proportionnelle à l'épaisseur de carbone souhaitée. Le carbone est déposé de façon localisée afin de définir, à la surface de la couche mince 102, une surface polluée alors que son environnement ne l'est pas ou peu. Le carbone qui compose la couche formée par insolation de la couche mince de semi-conducteur 102 provient de la pollution environnementale autour du substrat, et correspond par exemple à la pollution environnementale au sein d'un microscope électronique à balayage. Le faisceau d'électrons a par exemple une intensité égale à environ 0,58 µA et une tension d'environ 15 kV. Afin de comparer différents résultats pouvant être obtenus, on insole, sur chacun des quatre substrats, quatre zones respectivement pendant une durée d'environ 30 s, 60 s, 120 s et 300 s. Une insolation de 120 s forme une couche de carbone d'épaisseur moyenne égale à environ 0,5 nm. Une irradiation de 300 s forme une couche de carbone d'épaisseur moyenne égale à environ 1 nm.

Après 10 minutes d'un recuit à 900°C (sous ultravide), des agrégats, ou nanocristaux, carbonés, principalement composés de carbure de semi-conducteur, tel que du SiC, se forment sur la couche mince de semi-conducteur 102. La densité de ces agrégats est proportionnelle à l'épaisseur de la couche de carbone initialement formée. La hauteur de ces agrégats carbonés correspond à la hauteur des agrégats d'impuretés observée lorsqu'on ne réalise pas de traitement chimique de la surface de la couche mince 102 (hauteur comprise entre environ 5 nm et 20 nm). Pour chacune des différentes couches de carbone réalisées, on obtient des densités d'agrégats de SiC égales à : 15,8 agrégats/µm² (correspondant à la couche de carbone formée par une insolation de 30 s), 22,6 agrégats/µm² (correspondant à la couche de carbone formée par une insolation de 60 s), 34 agrégats/µm² (correspondant à la couche de carbone formée par une insolation de 120 s) et 52,6 agrégats/µm² (correspondant à la couche de carbone formée par une insolation de 300 s).

On voit donc que l'on peut contrôler la densité des agrégats carbonés de SiC, qui peut être comprise entre environ 0,1 et 1000 agrégats/µm² en choisissant au préalable l'épaisseur de la couche d'espèces carbonées déposée sur le silicium.

En prolongeant le recuit pendant 15 minutes, on observe alors le démouillage du silicium de la couche mince 102, formant les nanocristaux de silicium 108. La densité de ces nanocristaux 108 formés est proportionnelle à la densité des agrégats carbonés formés précédemment. Pour chacune des couches de carbone, on obtient des densités de nanocristaux de Si égales à environ 17,9 nanocristaux/µm² (correspondant à l'insolation de 30 s), 20,3 nanocristaux/µm² (correspondant à l' insolation de 60 s), 26,5 nanocristaux/µm² (correspondant à l'insolation de 120 s) et 37,6 nanocristaux/µm² (correspondant à l'insolation de 300s). De manière générale, dans ce second mode de réalisation, il est possible d'obtenir une densité de nanocristaux de semi-conducteur comprise entre environ 1 et 1000 agrégats/µm².

Les nanocristaux de semi-conducteur 108 formés sur la couche diélectrique 104 peuvent servir ensuite à réaliser des dispositifs électroniques de dimensions nanométriques, tels que les dispositifs mémoires dans lesquels les zones actives électriques correspondent aux nanocristaux 108, ou des dispositifs de type LED, comprenant une couche émettrice mettant à profit la photoluminescence des nanocristaux formés.

Dans une variante, il est possible de réaliser des nanocristaux de semi-conducteur en combinant les deux modes de réalisation précédemment décrits, c'est-à-dire en réalisant un traitement chimique de la surface de la couche mince de semi-conducteur 102 afin de réduire la quantité d'impuretés se trouvant sur la couche mince de semi-conducteur 102, puis en formant une couche de carbone, dont l'épaisseur sera choisie par exemple en fonction de la durée d'une insolation de la couche mince de semi-conducteur 102, et en réalisant ensuite un recuit entrainant la formation d'agrégats d'impuretés carbonées puis le démouillage du semi-conducteur de la couche mince 102. On peut ainsi mieux contrôler la quantité d'espèces carbonées formées sur le semi-conducteur en réduisant l'impact de la pollution environnementale. Dans ces conditions, seule la durée d'insolation peut avoir une influence sur la quantité d'espèces carbonées formées sur le semi-conducteur car la quantité d'espèces carbonées apportée par l'insolation est grande devant celle apportée par la pollution environnementale.

Enfin, cette réduction des dimensions des nanocristaux de semi-conducteur 108 peut également être accrue en contraignant le semi-conducteur de la couche mince 102. La contrainte subie par le semi-conducteur peut servir de paramètre pour modifier les dimensions et/ou la densité des nanocristaux de semi-conducteur. Plus la contrainte sera importante, plus la densité des nanocristaux de semi-conducteur obtenus sera importante et plus les dimensions de ces nanocristaux seront faibles.

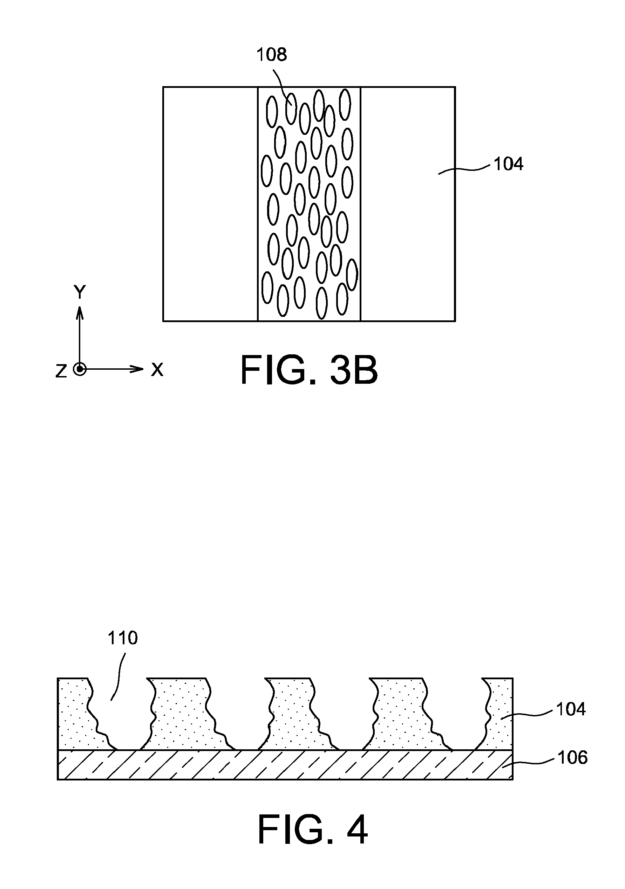

Lorsque le semi-conducteur est contraint, certains des nanocristaux formés par démouillage ont une forme allongée, par exemple rectangulaire. Lorsque le semi-conducteur est contraint de manière bi-axiale, l'orientation de ces nanocristaux, dans le plan de la couche de semi-conducteur, est aléatoirement répartie selon les directions cristallographiques principales de la couche mince de semi-conducteur 102. Afin de pouvoir choisir l'orientation de la majorité de ces nanocristaux de forme allongée, le semi-conducteur peut avantageusement être contraint uni-axialement. Une contrainte qualifiée d'uni-axiale correspond au cas où la contrainte ne s'exerce sur le semi-conducteur que dans une seule direction, mais également au cas où la contrainte s'exerce principalement sur le semi-conducteur selon une direction avec une intensité au moins deux fois, et de préférence au moins dix fois, supérieure aux intensités des éventuelles autres contraintes s'exerçant sur le semi-conducteur selon les autres directions. Dans ce cas, lors du démouillage, les nanocristaux 108 de forme allongée sont orientés perpendiculairement à l'axe de la contrainte du semi-conducteur. Ainsi, au moins 60 % des nanocristaux sont allongés et orientés perpendiculairement à l'axe de la contrainte. Préférentiellement, par comparaison à un semi-conducteur non-contraint, environ 90 % des nanocristaux ont une forme allongés et sont orientés perpendiculairement à l'axe de la contrainte dans le cas d'un contrainte d'environ 1,6 %, et environ 60 % des nanocristaux ont une forme allongés et sont orientés perpendiculairement à l'axe de la contrainte dans le cas d'un contrainte d'environ 0,8 %. La plus petite dimension de l'interface nanocristaux/couche diélectrique 104 est donc obtenue dans la direction dans laquelle la contrainte est initialement imposée afin de minimiser l'énergie totale du système. Les figures 3A et 3B représentent respectivement une vue en coupe de profil et une vue de dessus de nanocristaux 108 de forme allongée réalisés sur une portion rectangulaire 104a diélectrique contrainte uni-axialement selon l'axe Y (le semi-conducteur qui se trouvait initialement sur la portion 104a était contraint uni-axialement selon l'axe X).

Une telle couche de semi-conducteur contrainte uni-axialement peut être réalisée en utilisant un substrat comprenant une couche diélectrique 104 pré-contrainte disposée entre la couche mince 102 et la couche support 106, puis en gravant la couche mince 102 et la couche diélectrique 104 selon un motif tel que la contrainte s'exerçant sur la couche diélectrique 104 soit uni-axiale. Des exemples de réalisation d'une couche mince de semi-conducteur contrainte de manière uni-axiale sont par exemple décrits dans le document US 2006/091105 A1.

La contrainte peut aussi être apportée par une couche de matériau semi-conducteur contraint faisant partie de la couche support 106. La couche support 106 peut être formée d'un substrat silicium sur lequel a été épitaxié un alliage de silicium et de germanium dont la contrainte (ou la déformation) est définie par la concentration en germanium de cet alliage. Une fine couche de silicium peut former une interface entre l'alliage Si-Ge et l'empilement diélectrique 104. La couche mince 102 sera alors contrainte lors de la définition d'un motif par gravure successive de la couche mince 102, de la couche ou des couches diélectriques 104 et de tout ou partie de l'épaisseur de la couche d'alliage composée de Si-Ge.

Le recuit peut être réalisé jusqu'à ce que la totalité du semi-conducteur de la couche mince soit démouillé et forme les nanocristaux 108. En prolongeant le recuit (ou en commençant, après le démouillage, un autre recuit) après le démouillage de la totalité du semi-conducteur, et du fait de la haute température, les nanocristaux de silicium 108 réagissent avec le matériau de la couche diélectrique 104, indépendamment de la présence d'une contrainte ou non. Dans l'exemple décrit ici, on a la réaction : SiO₂ + Si -> 2 SiO. Du fait que le SiO s'évapore, le silicium forme alors au travers de la couche diélectrique 104 des trous 110 tels que représentés sur la figure 4. La réaction se produisant entre les nanocristaux de semi-conducteur et le matériau diélectrique peut consumer entièrement les nanocristaux. Les trous 110 ont une forme particulière due au déplacement en spirales des nanocristaux 108 lorsqu'ils « creusent » le SiO₂ de la couche diélectrique 104. Bien qu'irréguliers, ces trous 110 ont une forme sensiblement conique. Dans l'exemple décrit ici, les trous 110 traversent toute l'épaisseur de la couche diélectrique 104 et débouchent sur la couche épaisse de silicium 106.

Du fait que le procédé précédemment décrit permet de contrôler les dimensions et la densité des nanocristaux de silicium 108, il est donc possible de définir et contrôler les dimensions et la densité des trous 110 formés. La dimension de ces trous 110 au niveau de la face supérieure de la couche diélectrique 104 (correspondant initialement à l'interface entre les couches 102 et 104) est comprise entre environ 1 et 5 fois le diamètre des nanocristaux de semi-conducteur initialement formés avant leur réaction avec le matériau diélectrique de la couche 104. Les trous 110 formés ont une forme quasi-conique dont l'angle, par rapport à la direction perpendiculaire à la face supérieure de la couche diélectrique 104, est compris entre environ 30° et 75°, par exemple entre environ 40° et 65°. La taille des trous à l'interface entre les couches 104 et 106 dépend également de l'épaisseur de la couche 104.

Le procédé de réalisation de nanocristaux de semi-conducteur décrit précédemment permet donc, en prolongeant la durée du recuit, de réaliser un motif périodique de trous dont le positionnement et les dimensions sont contrôlables. La profondeur des trous formés étant fonction de la durée du recuit réalisé à partir de l'état démouillé de la couche semi-conductrice 102, la profondeur des trous 110 peut être contrôlée. L'épaisseur initiale de la couche de semi-conducteur 102, l'état de contrainte de la couche de semi-conducteur 102 ainsi que l'ajout d'impuretés carbonées sont des paramètres permettant de contrôler la taille et la densité des nanocristaux de silicium, mais également de contrôler la taille et la densité des trous 110.

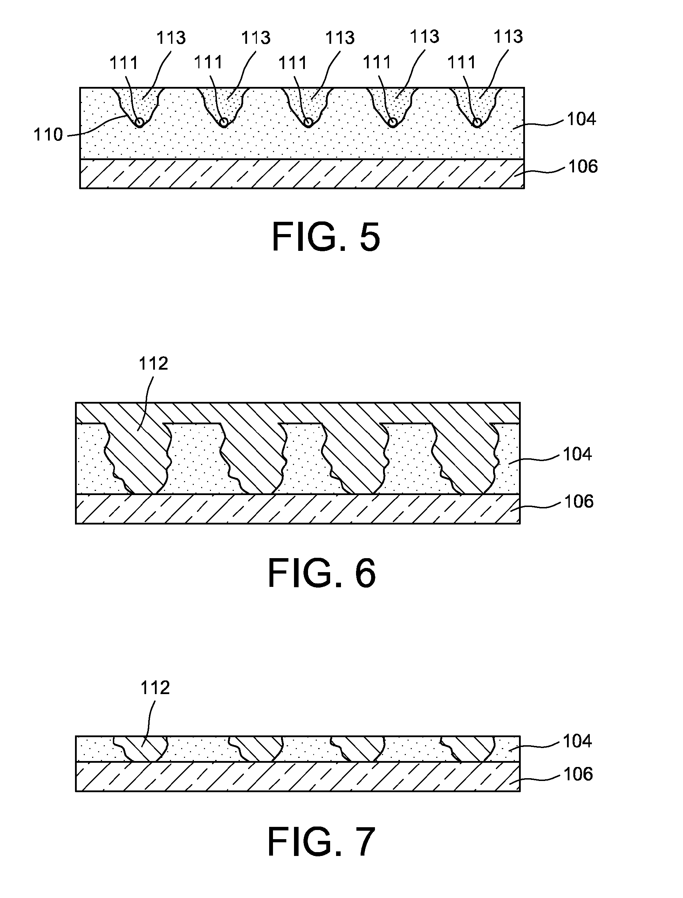

Il est possible d'interrompre le recuit avant que les trous 110 ne débouchent sur l'interface entre les couches 104 et 106. Dans ce cas, on retrouve au fond des trous 110 les nanocristaux de semi-conducteur partiellement consumés (en raison de la réaction du semi-conducteur des nanocristaux avec le diélectrique de la couche 104). Du fait qu'ils sont partiellement consumés, les dimensions de ces nanocristaux sont réduites par rapport aux dimensions initiales des nanocristaux. Les dimensions des nanocristaux de semi-conducteur résiduels disposés au fond des trous sont fonction de l'épaisseur initiale de la couche de semi-conducteur 102, de l'état de contrainte de la couche de semi-conducteur 102 ainsi que des densités d'impuretés carbonées formées sur la couche semi-conductrice 102. Ces dimensions peuvent varier entre 0 (cas où les nanocristaux sont totalement consumés) et les dimensions quasi-initiales des nanocristaux (dans le cas de trous de très faible profondeur). Les trous 110 peuvent ensuite être rebouchés, par exemple par un dépôt d'oxyde de silicium. Lorsque des nanocristaux de semi-conducteur résiduels sont présents au fond des trous, on obtient dans ce cas des nanocristaux enterrés au sein d'une couche diélectrique. Une telle structure est par exemple représentée sur la figure 5, dans laquelle des nanocristaux résiduels 111 sont disposés au fond des trous 110 qui sont bouchés par des portions de matériau diélectrique 113 disposées dans les trous 110 et recouvrant les nanocristaux de semi-conducteur résiduels 111. Une telle structure peut être utilisée pour des applications de type LED ou de dispositifs à piégeage de charges dans les nanocristaux. Dans ce cas, le diélectrique environnant sert à assurer le confinement des charges stockées dans les nanocristaux.

Une telle structure peut également être obtenue à partir d'une couche diélectrique 104 comprenant un empilement de différents matériaux diélectriques, par exemple un bicouche SiO₂/Si₃N₄ ou SiO₂/SiₓO_{y}N_{z}, ou tout autre empilement comprenant au moins deux matériaux diélectriques dont les cinétiques de réaction avec le semi-conducteur des nanocristaux sont différentes (la cinétique de réaction du matériau de la couche inférieure étant choisie beaucoup plus faible que celle du matériau de la couche supérieure par exemple composée de SiO₂). Dans ce cas, pour une couche diélectrique 104 correspondant par exemple à un bicouche SiO₂ / Si₃N₄, les trous 110 se forment dans le SiO₂ et l'interface entre le SiO₂ et le Si₃N₄ sous-jacent forme un lieu d'arrêt naturel des nanocristaux de silicium. La position finale des nanocristaux de semi-conducteur résiduels au sein de la couche diélectrique 104 peut donc être contrôlée par l'épaisseur de la couche de SiO₂. Comme précédemment, les trous formés dans SiO₂ peuvent être comblés par un dépôt d'un matériau, par exemple du SiO₂.

Il est également possible de prévoir l'épaisseur de la couche diélectrique 104 et les dimensions des nanocristaux de semi-conducteur telles que des nanocristaux de semi-conducteur résiduels sont présents après avoir traversés la totalité de l'épaisseur de la couche diélectrique 104, ces nanocristaux résiduels reposant dans ce cas sur la couche épaisse 106.

Dans tous les exemples précédemment décrits, la pureté chimique des nanocristaux de semi-conducteur est contrôlée puisque celle-ci correspond à la pureté chimique de la couche mince 102 réalisée en amont du procédé.

A partir de la couche diélectrique poreuse obtenue lorsque les trous 110 traversent complètement la couche diélectrique 104, il est possible de réaliser par exemple une matrice de vias conducteurs 112 entre les faces avant et arrière de la couche diélectrique 104. Pour cela, on peut réaliser un dépôt sous vide de métal (figure 6) remplissant les trous 110, puis un polissage afin de supprimer le métal se trouvant sur la face supérieure de la couche diélectrique 104 et dépassant des trous 110. Ce polissage peut également supprimer une partie de l'épaisseur de la couche diélectrique 104 afin de réduire les dimensions dans le plan (X,Y) des vias conducteur 112 (figure 7).

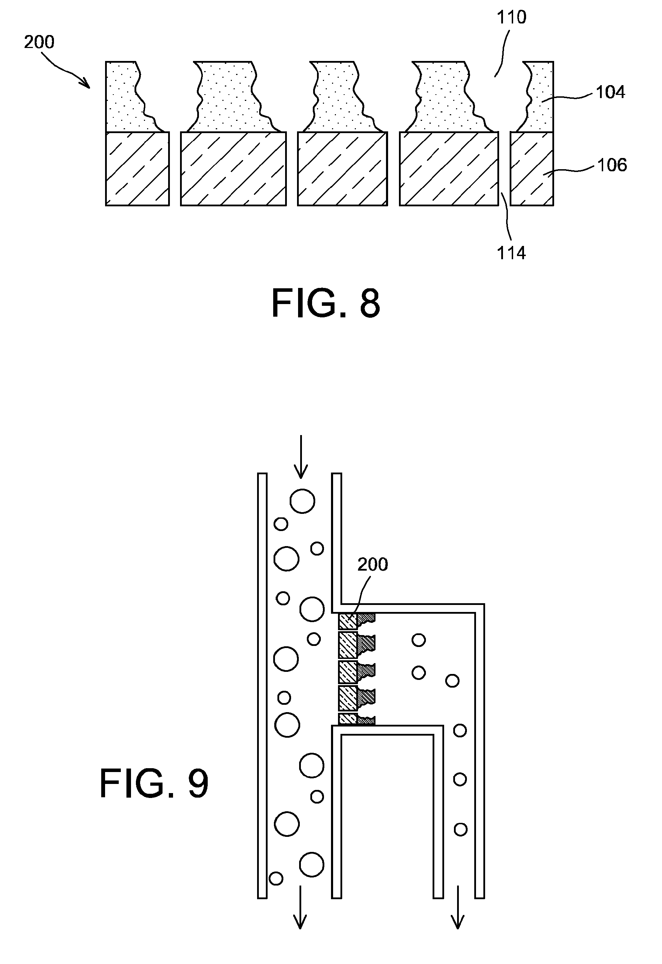

Dans un autre mode de réalisation, la couche diélectrique 104 poreuse obtenue peut servir de membrane microporeuse. Pour cela, la couche épaisse de silicium 106 peut être gravée telle que des trous 114, se trouvant à l'aplomb des trous 110 traversant la couche diélectrique 104, traversent toute l'épaisseur de la couche épaisse de silicium 106 (voir figure 8). On obtient ainsi une membrane poreuse 200 pouvant servir par exemple de filtre apte à séparer des molécules liquides ou gazeuses, comme représenté sur la figure 9. Cette membrane poreuse 200 peut également servir dans le domaine du diagnostic, des molécules biologiques pouvant être déposées dans les trous coniques, la membrane servant alors de détecteur.

## Revendications

1. Procédé de réalisation de nanocristaux de semi-conducteur (108), comportant au moins les étapes de :
- formation d'espèces chimiques carbonées solides sur une couche mince de semi-conducteur (102) disposée sur au moins une couche diélectrique (104), la densité des espèces chimiques carbonées formées sur la couche mince de semi-conducteur (102) étant fonction des dimensions et de la densité souhaitées des nanocristaux de semi-conducteur (108) ;
- recuit de la couche mince de semi-conducteur (102), réalisant un démouillage du semi-conducteur et formant, sur la couche diélectrique (104), les nanocristaux de semi-conducteur (108).

2. Procédé selon la revendication 1, dans lequel la formation d'espèces chimiques carbonées sur la couche mince de semi-conducteur (102) comporte une étape de traitement chimique de la couche mince de semi-conducteur (102) apte à réduire une quantité d'impuretés se trouvant sur la couche mince de semi-conducteur (102), et un recuit de la couche mince de semi-conducteur (102) décomposant les impuretés et formant des agrégats d'impuretés correspondant aux espèces chimiques carbonées.

3. Procédé selon la revendication 2, dans lequel l'étape de traitement chimique comporte l'application d'une solution composée de H₂O₂ et de H₂SO₄ contre la couche mince de semi-conducteur (102).

4. Procédé selon l'une des revendications précédentes, dans lequel la formation d'espèces chimiques carbonées sur la couche mince de semi-conducteur (102) comporte une étape de dépôt de carbone sur la couche mince de semi-conducteur (102), et un recuit de la couche mince de semi-conducteur (102) décomposant le carbone déposé et formant des agrégats de carbone correspondant auxdites espèces chimiques carbonées.

5. Procédé selon la revendication 4, dans lequel le dépôt de carbone sur la couche mince de semi-conducteur (102) est réalisé dans un environnement dont la pollution environnementale est composée d'espèces carbonées et comporte une insolation de la couche mince de semi-conducteur (102) par un faisceau d'électrons.

6. Procédé selon l'une des revendications précédentes, dans lequel le semi-conducteur de la couche mince (102) est contraint, la valeur de cette contrainte étant choisie en fonction des dimensions et de la densité souhaitées des nanocristaux de semi-conducteur (108).

7. Procédé selon la revendication 6, dans lequel le semi-conducteur de la couche mince (102) est contraint de manière uni-axiale.

8. Procédé selon l'une des revendications précédentes, dans lequel le recuit de la couche mince de semi-conducteur (102) formant les nanocristaux de semi-conducteur (108) est réalisé à une température comprise entre environ 600°C et 1250°C et dans un environnement sous ultravide.

9. Procédé selon l'une des revendications précédentes, dans lequel les étapes de formation des espèces chimiques carbonées et de recuit de la couche mince de semi-conducteur (102) sont mises en oeuvre dans un microscope électronique à balayage.

10. Procédé selon l'une des revendications précédents, dans lequel le recuit de la couche mince de semi-conducteur (102) est prolongé jusqu'à ce que les nanocristaux de semi-conducteur (108) réagissent chimiquement avec la couche diélectrique (104) en formant une pluralité de trous (110) traversant partiellement ou totalement la couche diélectrique (104).

11. Procédé selon la revendication 10, comportant en outre, après l'étape de recuit de la couche mince de semi-conducteur (102), une étape de bouchage des trous (110) par un dépôt d'au moins un matériau dans les trous (110).
